# EUROPEAN PATENT SPECIFICATION

(11) **EP 4 287 252 B1**
(45) Date of publication and mention of the grant of the patent: **30.09.2026**
(21) Application number: 23175976.2
(22) Date of filing: 30.05.2023
(51) Int. Cl.: H10W 40/00, H10W 40/60, H10W 76/15, H10W 40/20, H10W 40/25, H10W 90/00

(54) **POWER SEMICONDUCTOR MODULES AND METHOD FOR THEIR ASSEMBLING**
LEISTUNGSHALBLEITERMODULE UND VERFAHREN ZU DEREN MONTAGE
MODULES SEMI-CONDUCTEURS DE PUISSANCE ET LEUR PROCÉDÉ D'ASSEMBLAGE

(30) Priority: 30.05.2022 CN 202210600902
(43) Date of publication of application: 06.12.2023
(73) Proprietor: Nexperia Technology (Shanghai) Ltd., Shanghai 200025 (CN); Nexperia B.V., 6534 AB Nijmegen (NL)
(72) Inventor: Qian, Qiuxiao, Shanghai (CN); Zhu, Chunlin, Shanghai (CN); Jiang, Ke, Shanghai (CN)
(74) Representative: Pjanovic, Ilija

(56) References cited:
- CN-A- 112 490 195
- DE-A1- 3 505 085
- FR-A3- 2 841 664
- US-A1- 2008 158 822
- US-A1- 2014 285 973
- US-B1- 6 205 026

## Description

### Technical Field

The present invention relates to power semiconductor modules, and methods for assembling the power semiconductor module.

### Background

During operation, power semiconductor chips generate heat, which needs to be dissipated to maintain the proper functions of the power semiconductor chips. Furthermore, power semiconductor chips are often integrated by using a power semiconductor module with a housing. Compared with discrete chips or devices, power semiconductor modules are easier to be used, but have higher heat dissipation requirements.

A common manner of heat dissipation for a power semiconductor module is to make a heat-dissipation contact area coated with heat conductive silicone grease at the bottom of the module directly contact with a heat sink element (comprising a cooling element) to dissipate heat generated by a semiconductor chip and the like in the power semiconductor module to the environment through the heat conductive silicone grease and the heat sink element. However, the size of the power semiconductor module is generally big, and portions near the edges of the power semiconductor module are gradually warped as heat is generated. On the other hand, since the heat conductive silicone grease has fluidity, when the power semiconductor module is attached to the heat sink element, the heat conductive silicone grease between the power semiconductor module and the heat sink element is squeezed to fill up a gap between the bottom of the power semiconductor module and the heat sink element. Therefore, the larger the warpage is, the larger the local gap between the heat-dissipation contact area and the heat sink element is, and hence the thicker the heat conductive silicone grease in local regions is. Since the heat conductivity of the heat conductive silicone grease is lower than that of the heat sink element, and the heat dissipation capability of the heat conductive silicone grease is also inferior to that of the heat sink element, excessive warpage is likely to hinder the heat dissipation efficiency of the power semiconductor module.

In order to solve the warpage problem of the power semiconductor module during use, the prior art has the following two designs.

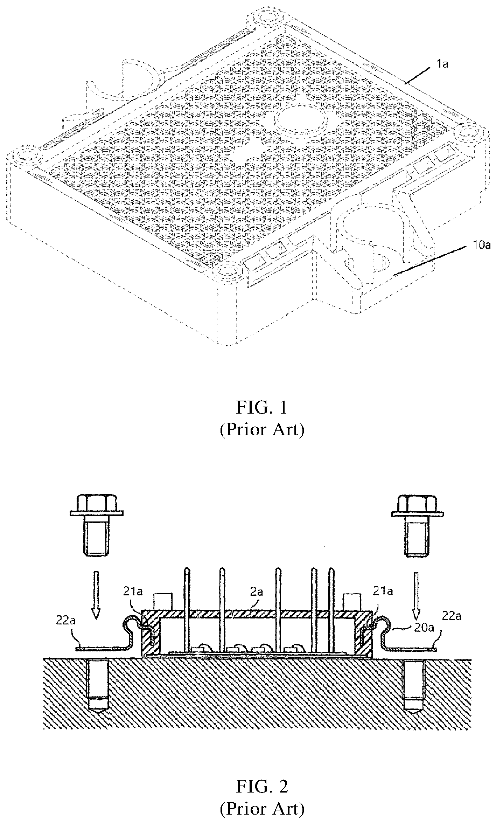

One design in the prior art is disclosed in, for example, USD0922329S, in which, as shown in FIG. 1, two flanges 10a with through holes are integrally formed at lower portions on both sides of a housing 1a of a power semiconductor module. Screw holes are correspondingly formed in a heat sink element, and the housing is fixed to the heat sink element with screws (or bolts) passing through the through holes. In this design, the contact between the power semiconductor module and the heat sink element is a rigid contact, which is not only disadvantageous to reduce the gap between the heat-dissipation contact area and the heat sink element, but also prone to aging at the stressed positions, which is disadvantageous to long-term use. Furthermore, the design shown in FIG. 1 is less reliable in a vibrating environment.

Another design in the prior art is disclosed in, for example, US7477518B2, in which, as shown in FIG. 2, a plastic housing 2a molded with press-on elements is applied. When manufacturing the power semiconductor module, one end 21a of the press-on element 20a is inserted into a plastic injection molding die for making the housing, thereby embedding the press-on element into the side wall of the housing while injection molding the housing. The other end 22a of the press-on element is provided with a through hole, and the housing 2a is fixed to the heat sink element with a screw (or bolt) passing through the through hole similarly. Although the design shown in FIG. 2 enables flexible contact between the press-on element and the heat sink element, which is beneficial for long-term use, it leads to a complicated manufacturing process of the housing and a high manufacturing cost.

Furthermore, both designs shown in FIG. 1 and 2 result in the power semiconductor module being applicable only to glue-filled plastic modules, but not to plastic encapsulated modules. Specifically, the housing of the plastic module is typically manufactured separately. During packaging, the plastic housing and the substrate (such as a copper-clad ceramic substrate or a copper substrate) are bonded by glue, and then the silicone gel is poured into the plastic housing. In contrast, for plastic encapsulated modules, typically, a thermosetting material such as an Epoxy Molding Compound (EMC) is extruded into a mold cavity and embeds the semiconductor chips therein. This method is not suitable for manufacturing the portion of the housing to which the heat sink element is fixed (e.g., the above-described flange 10a and the pressing member 20a). The two designs shown in FIG. 1 and 2 are not suitable for plastic encapsulated modules. In addition, the size of the power semiconductor module thus produced is big, which is not advantageous to the packaging process and the baling and transporting. An additional, similar design is disclosed in DE 35 05 085 A1.

Therefore, it is desirable to provide an improved power semiconductor module that can solve the above technical problems.

### Summary

The present invention provides a power semiconductor module as claimed in claim 1 and a method for assembling the power semiconductor module, as claimed in claim 18.

Specifically, the present invention provides a power semiconductor module, including: a heat-dissipation contact area configured for thermal connection with a heat sink element; a housing; and a press-on element manufactured separately from the housing. One of the housing and the press-on element includes a rail portion, and the other includes a rail cooperating portion. One of the housing and the press-on element includes a first limiting portion, and the other includes a first limiting cooperating portion. The rail cooperating portion is capable of being inserted into the rail portion and sliding in the rail portion in a direction toward or away from a plane where the heat-dissipation contact area is located, such that the press-on element is capable of moving from a separation position in which the press-on element is separated from the housing to a mounted position in which the press-on element is connected to the housing. The rail portion is capable of cooperating with the rail cooperating portion to prevent the press-on element from moving relative to the housing in a direction parallel to the plane where the heat-dissipation contact area is located. The first limiting portion is capable of cooperating with the first limiting cooperating portion to prevent the press-on element from moving relative to the housing in a direction toward the plane where the heat-dissipation contact area is located when the press-on element is in the mounted position. The press-on element is configured to press the heat-dissipation contact area against the heat sink element when the press-on element is in the mounted position and the press-on element is mounted to the heat sink element, via a screw within an inner mounting ring in the surface of the press-on element to be coupled to the heat sink. The inner mounting ring is connected to and surrounded by an outer mounting ring, which in turn is connected to the surface of the press-on element to be coupled to the housing.

Optionally, the rail portion is located on the housing. The press-on element further includes a main body portion. The rail cooperating portion is configured to project laterally from the main body portion and extend in a direction in which the rail portion extends.

Optionally, the press-on element is configured to be adapted to move from an entry position on a side of the housing close to the heat-dissipation contact area to the mounted position in a direction away from the plane where the heat-dissipation contact area is located. The first limiting portion is configured as a protrusion on the housing. The protrusion has a non-returning surface facing away from the plane where the heat-dissipation contact area is located, and a guiding surface extending obliquely from a tip end of the non-returning surface toward the heat-dissipation contact area. The guiding surface is used for guiding the main body portion during the movement of the press-on element from the entry position to the mounted position. The first limiting portion is configured as a window on the main body portion. When the press-on element is in the mounted position, the protrusion passes through the window, and the non-returning surface of the protrusion is capable of cooperating with a surface of the window facing the plane where the heat-dissipation contact area is located to prevent the press-on element from moving relative to the housing in a direction toward the plane where the heat-dissipation contact area is located.

Optionally, the press-on element is configured to be adapted to move from an entry position on a side of the housing close to the heat-dissipation contact area to the mounted position in a direction away from the plane where the heat-dissipation contact area is located. The first limiting portion is configured as a recess on the housing. The first limiting portion is configured as an elastic element on the main body portion. When the press-on element is in the mounted position, the elastic element is capable of cooperating with the recess to prevent the press-on element from moving relative to the housing in a direction toward the plane where the heat-dissipation contact area is located.

Optionally, the elastic element is an elastic sheet that is bent and/or tilted toward the housing. When the press-on element is in the mounted position, a tip end of the elastic sheet abuts against a surface of the recess facing away from the plane where the heat-dissipation contact area is located.

Optionally, the press-on element is configured to be adapted to move from an entry position on a side of the housing away from the heat-dissipation contact area to the mounted position in a direction toward the plane where the heat-dissipation contact area is located. The first limiting portion is a first stop surface on the housing. When the press-on element is in the mounted position, the first limiting cooperating portion is capable of cooperating with the first stop surface to prevent the press-on element from moving relative to the housing in a direction toward the plane where the heat-dissipation contact area is located.

Optionally, the rail portion is located on the housing. The first stop surface is located in a portion of the rail portion close to the heat-dissipation contact area. The rail cooperating portion is located on the press-on element. When the press-on element is in the mounted position, the first limiting cooperating portion is located at an end of the rail cooperating portion. The first limiting cooperating portion is capable of cooperating with the first stop surface to prevent the press-on element from moving relative to the housing in a direction toward the plane where the heat-dissipation contact area is located.

Optionally, the press-on element is made of a material having elasticity.

Optionally, the housing and the press-on element include a second limiting portion and a second limiting cooperating portion, respectively. When the press-on element is in the mounted position, the second limiting portion is capable of cooperating with the second limiting cooperating portion to prevent the press-on element from moving relative to the housing in a direction away from the plane where the heat-dissipation contact area is located.

Optionally, the housing and the press-on element include a second limiting portion and a second limiting cooperating portion, respectively. **The** second limiting portion is configured as a second stop surface facing the plane where the heat dissipation contact area is located. **The** second limiting cooperating portion is located at an end of the main body portion or the rail cooperating portion. When the press-on element is in the mounted position, the second stop surface is capable of cooperating with the second limiting cooperating portion to prevent the press-on element from moving relative to the housing in a direction away from the plane where the heat-dissipation contact area is located.

Optionally, the second limiting portion is configured as a protrusion on the housing. **The** protrusion has a non-returning surface facing away from the plane where the heat-dissipation contact area is located, and a guiding surface extending obliquely away from the plane where the heat-dissipation contact area is located from a tip end of the non-returning surface. **The** guiding surface is used for guiding the main body portion during the movement of the press-on element from the entry position to the mounted position. **The** second limiting portion is configured as a window on the main body portion. When the press-on element is in the mounted position, the protrusion passes through the window, and the non-returning surface of the protrusion is capable of cooperating with a surface of the window away from the plane where the heat-dissipation contact area is located to prevent the press-on element from moving relative to the housing in a direction away from the plane where the heat-dissipation contact area is located.

Optionally, a self-locking structure is provided on the non-returning surface. **The** self-locking structure is configured to be capable of cooperating with the window to prevent the press-on element in the mounted position from moving outward in a direction away from the housing.

Optionally, the numbers of the rail portions and the rail cooperating portions are two, respectively. The spaces in the two rail portions for accommodating the corresponding rail cooperating portions are opened toward each other.

Optionally, the number of the press-on elements is at least two. In the mounted position, two of the press-on elements are mounted on opposite sides of the housing, respectively.

Optionally, the press-on element is adapted to be detachably mounted to the housing.

Optionally, the first limiting portion is integrally formed on the housing.

Optionally, the first limiting cooperating portion is integrally formed on the press-on element.

Optionally, the rail portion is integrally formed on the housing or the press-on element.

Optionally, the rail cooperating portion is integrally formed on the housing or the press-on element.

Optionally, the housing is made of plastic.

Optionally, the press-on element is made of metal.

The present invention also provides method for assembling the above-mentioned power semiconductor module to the heat sink element, the method including: placing the press-on element at an entry position on the housing, sliding the rail cooperating portion in the rail portion to move the press-on element from the entry position to the mounted position; and mounting the press-on element on the heat sink element such that the heat-dissipation contact area abuts against the heat sink element tightly.

Optionally, before mounting the press-on element to the heat sink element, the method further includes: applying a heat conductive silicone grease on the heat-dissipation contact area and/or the surface of the heat sink element.

The power semiconductor module and the method for assembling the same provided by the present invention have the following advantages: making the power semiconductor modules less difficult to product, widely applicable, have long service life and small size, easy to package, bale and transport, capable of inhibiting the occurrence of warping in long-term use and keeping stable contact between the heat-dissipation contact area and the heat sink element.

### Brief Description of the Drawings

FIG. 1 is a design of a housing and a hold-down press-on member element of a power semiconductor module in the prior art;
FIG. 2 is another design of a power semiconductor module including a housing and a press-on element in the prior art;
FIG. 3 is a schematic cross-sectional view of a power semiconductor module with a press-on element in a mounted position according to a first embodiment of the present invention;
FIG. 4 is a top perspective view of the power semiconductor module with the press-on element in the mounted position according to the first embodiment of the present invention;
FIG. 5 is a top view of the power semiconductor module of FIG. 4;
FIG. 6 is a top perspective view of the housing and the press-on element of the power semiconductor module with the press-on element in a separation position according to the first embodiment of the present invention;
FIG. 7 is a schematic view showing the mounting process of the press-on element according to the first embodiment of the present invention;
FIG. 8 is a schematic cross-sectional view of the power semiconductor module mounted to the heat sink element according to the first embodiment of the present invention;
FIG. 9 is a perspective view of a housing of a power semiconductor module with a press-on element in the mounted position according to a second embodiment of the present invention;
FIG. 10 is a perspective view of the housing of the power semiconductor module with the press-on element in the separation position according to the second embodiment of the present invention;
FIG. 11 is a side view of the press-on element of the power semiconductor module according to the second embodiment of the present invention;
FIG. 12 is a perspective view of a housing of a power semiconductor module with a press-on element in the mounted position according to a third embodiment of the present invention;
FIG. 13 is a perspective view of the housing of the power semiconductor module with the press-on element in the separation position according to the third embodiment of the present invention;
FIG. 14 is a perspective view of a housing and a press-on element of a power semiconductor module according to a fourth embodiment of the present invention; and
FIG. 15 is a partially enlarged view of a housing of a power semiconductor module according to a fifth embodiment of the present invention.

### Detailed Description of the Embodiments

The present invention will now be described, by way of examples, with reference to the accompanying drawings. The following description discloses or illustrates various objects, features and aspects of the present invention. It will be understood by those skilled in the art that the following discussion is intended to describe exemplary embodiments only, and is not intended as limiting the broader aspects of the present invention, which are embodied in the exemplary constructions. Table 1 is a list of components in the drawings along with corresponding reference numerals, wherein the same or similar reference numerals to each other denote the same or similar components to each other in the drawings. Thus, once a component is defined in one embodiment, further definition and explanation of thereof may be omitted in other embodiments.

**Table 1**

| Reference numeral | Component |
|---|---|
| 1 | power semiconductor module |
| 10; 110; 210; 310 | housing |
| 11; 111; 211; 311 | rail portion |
| 12; 215; 312 | protrusion |
| 13; 213 | non-returning surface |
| 14; 214 | guiding surface |
| 15 | second stop surface |
| 16 | projection where the second stop surface 15 is located |
| 17 | self-locking structure |
| 20; 120; 220; 320 | press-on element |
| 21; 121; 221; 321 | rail cooperating portion |
| 22; 225; 322 | window |
| 23; 123; 223; 323 | main body portion |
| 25 | upper end portion of rail cooperating portion 21 |
| 125 | upper end portion of rail cooperating portion 121 |
| 30 | heat-dissipation contact area |
| 41 | power semiconductor substrate |
| 42 | power semiconductor chip |
| 43 | terminal pin |
| 44 | screw |
| 112 | recess |
| 122 | elastic element |
| 212 | first stop surface |
| 222 | lower end portion of rail cooperating portion 221 |
| D | heat sink element |

In the description of the present invention, it should be noted that the terms "top", "bottom", "upper", "lower", "left", "right", "inner", "outer", and the like indicate orientations or positional relations based on orientations or positional relations shown in the drawings or orientations or positional relations that a product is conventionally arranged when in use, and are merely used for convenience of description and simplification of description, but do not indicate or imply that the device or element referred to must have a specific orientation, be constructed and operated in a specific orientation. Therefore, they should not be construed as limiting the present invention. Of course, when the power semiconductor module is mounted in a circuit, the positional relationship between the components should be based on the actual orientation.

Furthermore, in the description of the present invention, unless otherwise specified, expressions in the singular form may include concepts in the plural.

Furthermore, the terms "first," "second," and the like are used solely to distinguish one element from another, but should not be understood as indicating or implying relative importance or order.

In addition, it should be noted that the features in the embodiments of the present invention could be arbitrarily combined with each other in case of no conflict.

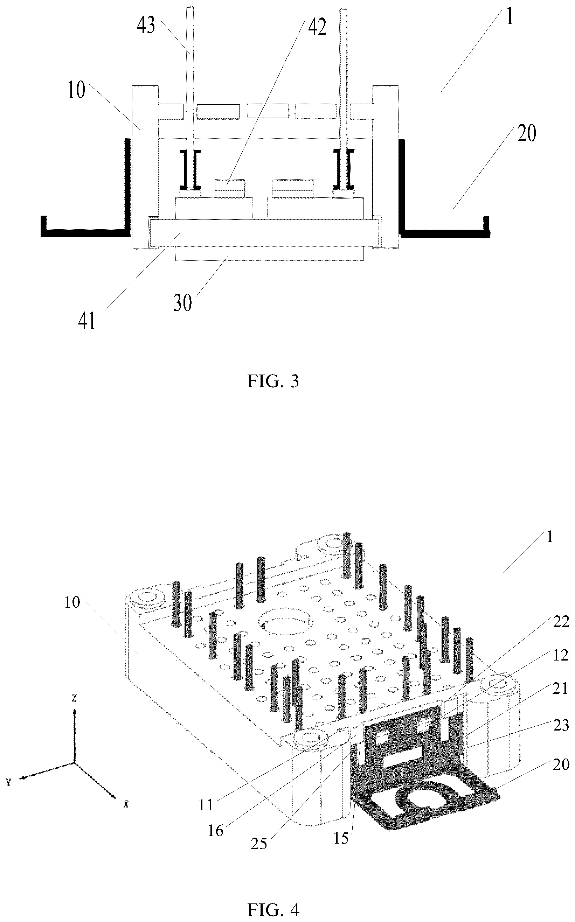

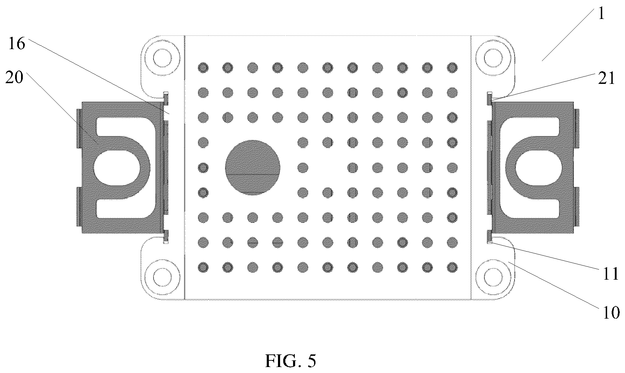

FIGS. 3 to 14 show power semiconductor modules (1) according to different embodiments of the present invention. The power semiconductor module (1) includes a housing (10; 110; 210; 310), a press-on element (20; 120; 220; 320) and a heat-dissipation contact area 30. The heat-dissipation contact area 30 is configured for thermal connection with a heat sink element D. One of the housing element (10; 110; 210; 310) and press-on element (20; 120; 220; 320) includes a rail portion (11; 111; 211; 311), and the other includes a rail cooperating portion (21; 121; 221; 321). As an example, in FIGS. 4 to 13, the rail portions (11; 111; 211) are all on the housing (10; 110; 210) and the rail cooperating portions (21; 121; 221) are all on the press-on element (20; 120; 220).

The rail cooperating portion (21; 121; 221; 321) is capable of being inserted into the rail portion (11; 111; 211; 311) and sliding in the rail portion (11; 111; 211; 311) in a direction toward or away from the plane where the heat-dissipation contact area 30 is located (i.e. in the up-down direction), so that press-on element (20; 120; 220; 320) is capable of moving from a separation position, in which the press-on element is separated from the housing (10; 110; 210; 310), to a mounted position, in which the press-on element is connected to housing (10; 110; 210; 310). The rail portion (11; 111; 211; 311) is capable of cooperating with the rail cooperating portion (21; 121; 221; 321) to prevent the press-on element (20; 120; 220; 320) from moving relative to the housing (10; 110; 210; 310) in a direction parallel to the plane in which the heat-dissipation contact area lies, i.e. in a lateral plane. In other words, the cooperation of the rail portion (11; 111; 211; 311) and the rail cooperating portion (21; 121; 221; 321) only prevents movement in the lateral plane, but allows movement in the up-down direction.

The housing (10; 110; 210; 310) and the press-on element (20; 120; 220; 320) respectively include a first limiting portion (12; 112; 212; 312) and a first limiting cooperating portion (22; 122; 222; 322). One of the housing (10; 110; 210; 310) and the press-on element (20; 120; 220; 320) includes the first limiting portion (12; 112; 212; 312), and the other includes the first limiting cooperating portion (22; 122; 222; 322). For example, in FIGS. 4-14, the first limiting portions (12; 112; 212; 312) are all on the housing (10; 110; 210; 310), and the first limiting cooperating portions (22; 122; 222; 322) are all on the press-on element (20; 120; 220; 320). When the press-on element (20; 120; 220; 320) is in the mounted position, the first limiting portion (12; 112; 212; 312) could cooperate with the first limiting cooperating portion (22; 122; 222; 322) to prevent the press-on element (20; 120; 220; 320) from moving relative to the housing (10; 110; 210; 310) in the direction toward the plane where the heat-dissipation contact area 30 is located, i.e. moving downward in FIGS. 3 to 4 and 6 to 14. In other words, the first limiting portion (12; 112; 212; 312) and the first limiting cooperating portion (22; 122; 222; 322) are used for preventing the press-on element from moving downward relative to the housing after the press-on element (20; 120; 220; 320) reaches the mounted position. That is, the first limiting portion and the first limiting cooperating portion do not limit the relative movement between the press-on element and the housing during the movement of the press-on element.

The press-on element (20; 120; 220; 320) is configured for pressing the heat-dissipation contact area 30 against heat sink element D when the press-on element is in the mounted position and is mounted to the heat sink element. In other words, when the power semiconductor module (1) is mounted on heat sink element D, the heat sink element D is respectively in contact with the heat-dissipation contact area 30 and fixed to the press-on element (20; 120; 220; 320), so that the press-on element (20; 120; 220; 320) is prevented from moving upward relative to the housing.

Through the above design, the power semiconductor module of the present invention has the following advantages: low production difficulty, wide application range, long service life, small size, convenience for packaging, baling and transporting, capability of inhibiting the occurrence of warping in long-term use and keeping stable contact between the heat-dissipation contact area and the heat sink element.

As shown in FIGS. 4-13, in various embodiments of the present invention, the rail portion (11; 111; 211) may be located on housing (10; 110; 210). The press-on element (20; 120; 220) further includes a main body portion (23; 123; 223). The rail cooperating portion (21; 121; 221) is configured to project laterally from the main body portion (23; 123; 223) and extend in a direction in which the rail portion (11; 111; 211) extends. In other words, the rail portion (11; 111; 211) and the rail cooperating portion (21; 121; 221) both extend in the up-down direction. The rail portion (11; 111; 211) is provided on the housing (10; 110; 210) to facilitate the manufacture of the housing (10; 110; 210) and the press-on element (20; 120; 220).

According to embodiments of the present invention, as shown in FIGS. 4 to 11, the press-on element (20; 120) may be configured to be adapted to move from an entry position on a side of the housing (10; 110) close to the heat-dissipation contact area 30 (i.e., the lower side of the housing) to a mounted position in a direction away from the plane where the heat dissipation contact area 30 is located (i.e., upward). Through this structure, the press-on element (20; 120) could be positioned at the mounted position more easily in the mounting process.

According to the embodiments of the present invention, the spaces in the two rail portions for accommodating the corresponding rail cooperating portions are opened toward each other.

According to the embodiments of the present invention, the number of the press-on elements (20; 120; 220; 320) may be at least two. When in the mounted position, two of the press-on elements (20; 120; 220; 320) are mounted on opposite sides of the housing (10; 110; 210; 310), respectively.

According to the embodiments of the present invention, the press-on element (20; 120; 220; 320) may be adapted to be detachably mounted to the housing (10; 110; 210; 310).

According to the embodiments of FIGS. 4 to 14, the first limiting portion (12; 112; 212; 312) may be integrally formed on the housing (10; 110; 210; 310). The first limiting cooperating portion (22; 122; 222; 322) may be integrally formed on the press-on element (20; 120; 220; 320). The rail portion may be integrally formed on the housing (10; 110; 210) or the press-on element 320. The rail cooperating portion may be integrally formed on the housing 310 or the press-on element (20; 120; 220). The housing (10; 110; 210; 310) may be made of plastic. The press-on element (20; 120; 220; 320) may be made of metal (for example, a thin metal sheet) or high polymer material. The metal may be aluminum, magnesium alloy, copper, nickel-plated copper, stainless steel and the like, and the high polymer material may be plastic or high polymer material mixed with filler. The press-on element (20; 120; 220; 320) may be an elastic element.

In the embodiments of the present invention, the cooperation between the first limiting portion (12; 112; 212; 312) and the first limiting cooperating portion (22; 122; 222; 322) may be contact cooperation or snap cooperation. Alternatively, the cooperation between the first limiting portion and the first limiting cooperating portion may also be bolt cooperation or screw cooperation.

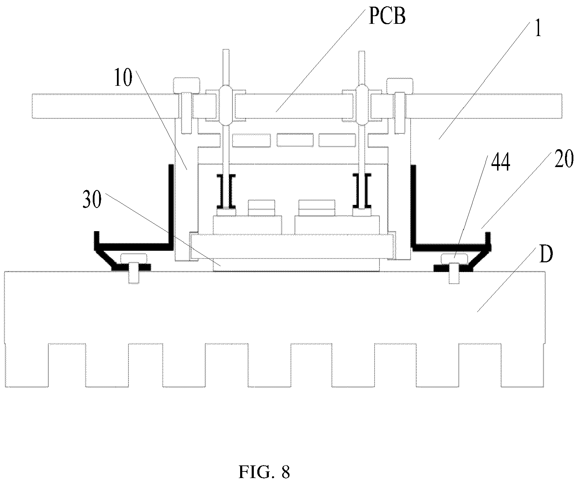

According to embodiments of the present invention, a method for assembling the above-mentioned power semiconductor module to a heat sink element includes: placing the press-on element (20; 120; 220; 320) at an entry position on housing (10; 110; 210; 310), sliding the rail cooperating portion in the rail portion to move the press-on element from the entry position to the mounted position; and mounting the press-on element (20; 120; 220; 320) on the heat sink element such that the heat-dissipation contact area abuts against the heat sink element 30 tightly. FIG. 8 shows the power semiconductor module in the mounted state.

Optionally, prior to mounting the press-on element (20; 120; 220; 320) to the heat sink element, the method further includes: the power semiconductor module assembling method further includes: applying a heat conductive silicone grease on the heat-dissipation contact area 30 and/or the surface of the heat sink element.

Hereinafter, various embodiments of the present invention will be described in detail.

### First embodiment

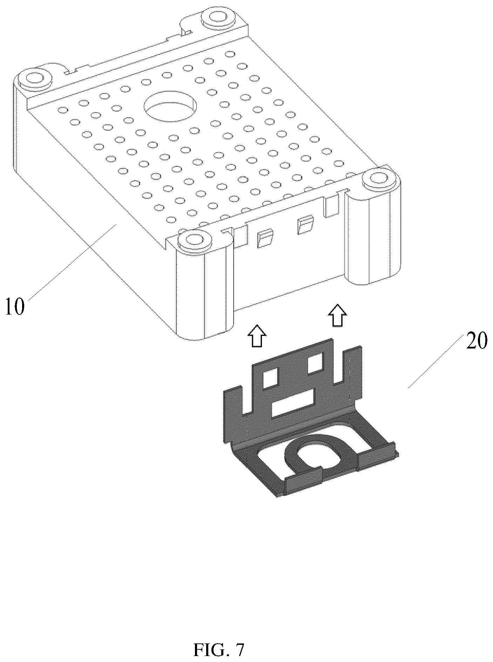

FIGS. 3 to 8 show a power semiconductor module 1 according to the first embodiment of the present invention. FIGS. 3 and 8 are schematic cross-sectional views of power semiconductor module 1 in various different states, FIGS. 4 to 6 are views of the power semiconductor module 1 in various different states and seen from various angles, and FIG. 7 is a schematic view of an assembly process of a press-on element 20 of the power semiconductor module 1.

As shown in FIGS. 3 to 5 and 8, the power semiconductor module 1 includes a housing 10, a press-on element 20, and a heat-dissipation contact area 30. Typically, the housing 10 has a substantially rectangular parallelepiped shape, although other shapes (e.g., trapezoidal platforms, trapezoidal columns, hexagonal columns, etc.) are also possible. The heat-dissipation contact area 30 is an area of the power semiconductor module 1 for thermal connection with a heat sink element D (see FIG. 8). The heat-dissipation contact area 30 is the bottom surface of a power semiconductor substrate 41, and the power semiconductor substrate 41 is a DBC (direct bonded copper) substrate and is embedded at the bottom of the housing. Power semiconductor chips 42 and the like are provided on the top surface of the power semiconductor substrate 41 and are located within the housing 10, and a plurality of terminal pins 43 extend from the power semiconductor chip 42 or the power semiconductor substrate 41 toward a direction away from the heat-dissipation contact area 30 (i.e., in the Z-axis direction in FIG. 4) and pass out of the housing 10 from through holes at the top of the housing 10. The housing 10 may be filled with silicone gel.

The press-on element 20 is manufactured separately from the housing 10, and the press-on element 20 can be mounted to the housing 10 through a simple assembly process. In the first embodiment, two press-on elements 20 may be mounted on opposite sides of the housing 10, respectively. For clarity, only one of the press-on elements 20 and its associated housing structure will be described.

As shown in FIGS. 4 to 8, the press-on element 20 may include a substantially vertical portion to be cooperated with the housing 10, and a substantially horizontal portion to be cooperated with the heat sink element D, thereby forming a substantial L shape. The substantially vertical portion includes a main body portion 23 and rail cooperating portions 21 on both sides of the main body portion 23. The two rail cooperating portions 21 laterally project from the lower portion of the main body portion 23 opposite to each other, and then extend upwardly, thereby forming a gap between each rail cooperating portion 21 and the main body portion 23. The press-on element 20 may be an elastic element made of a material having certain elasticity (for example, a metal such as aluminum, magnesium alloy, copper, nickel-plated copper, or stainless steel; a polymer material such as plastic; or a polymer material doped with a filler).

Two rail portions 11 corresponding to the two rail cooperating portions 21 are formed in parallel with each other on the side wall of the housing 10. Optionally, the spaces of the two rail portions 11 for accommodating the rail cooperating portions 21 are opened toward each other (for example, cross sections of the two rail portions 11 taken by a plane parallel to the plane where the heat-dissipation contact area 30 is located may have 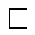 shape and 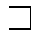 shape facing each other, respectively).

The rail cooperating portions 21 are slidable within the rail portions 11 in a direction toward or away from the plane where the heat-dissipation contact area 30 is located (i.e., in Z-axis direction or an up-down direction in FIG. 4), so that the press-on element 20 could be moved from a separation position (see FIG. 7), in which the press-on element is separated from the housing 10, to a mounted position (see FIG. 4), in which the press-on element is connected to housing 10. More specifically, the press-on element 20 could be moved vertically upward from an entry position on the lower side of the housing 10 to the mounted position. No matter in the sliding process of the rail cooperating portion 21 or after the press-on element 20 has been in the mounted position, the rail portions 11 are capable of cooperating with the rail cooperating portions 21 to prevent the press-on element 20 from moving relative to the housing 10 in a direction parallel to the plane where the heat-dissipation contact area 30 is located (i.e., in any direction perpendicular to the Z-axis in FIG. 4). In other words, the cooperation between the rail portions 11 and the rail cooperating portions 21 only allows the press-on element 20 to move in the up-down direction. Therefore, once the press-on element 20 has been mounted to the housing 10, the press-on element 20 is prevented by the rail portions 11 from moving in the left-right direction (Y-axis direction in FIG. 4) or the front-back direction (X-axis direction in FIG. 4).

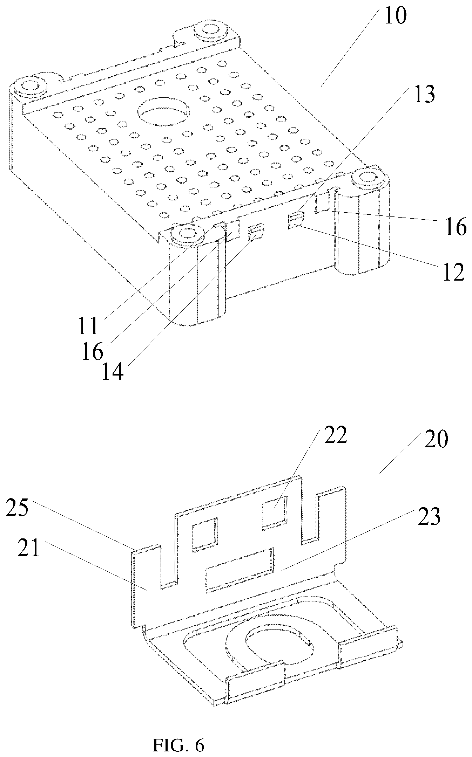

In addition, the housing 10 is provided with a first limiting portion. In the first embodiment, as shown in FIGS. 4 and 6, the first limiting portion is configured in the form of protrusions 12. The protrusions 12 and the rail corresponding portions 11 are provided on the same side wall surface of the housing 10, and the protrusions 12 are preferably located between the two rail portions 11. Each protrusion 12 has an upwardly facing non-returning surface 13 and a guiding surface 14 extending obliquely downward from the vicinity of the end of the non-returning surface 13. A transition surface may optionally be provided between the non-returning surface 13 and the guiding surface 14. That is, the guiding surface 14 terminates at its upper end in the non-returning surface 13 or the transition surface and at its lower end in the side wall of the housing 10. The guiding surface 14 may be a slope or a surface having a certain curvature.

First limiting cooperating portions, which correspond to the respective first limiting portions, are provided on the press-on element 20. In the first embodiment, the first limiting cooperating portions are windows 22 opened on the main body portion 23. Each window 22 may be rectangular in shape and sized to fit the protrusion 12. However, the window 22 may also be sized slightly larger than the protrusion 12.

As shown in FIG. 4, when the press-on element 20 is in the mounted position mounted on the housing 10, the protrusions 12 on the housing 10 could cooperate with the windows 22 on the press-on element 20 to prevent the press-on element 20 from moving downward relative to the housing 10. More specifically, when the press-on element 20 is in the mounted position, each protrusion 12 pass through the respective window 22, and the upward non-returning face 13 of the protrusion 12 could prevent the press-on element 20 from moving downward relative to the housing 10 by abutting against the downward surface of the window 22 (i.e., the upper edge of the window 22).

Further, the housing 10 and the press-on element 20 may include a second limiting portion and a second limiting cooperating portion, respectively. In the first embodiment, as shown in FIG. 4, the second limiting cooperating portion is an upper end portion 25 of each rail cooperating portion 21. The second limiting portion is a second stop surface 15 which faces downward and could cooperate with the upper end 25 of the rail cooperating portion 21. Each second stop surface 15 could be located between the corresponding rail portion 11 and protrusion 12, and could be a lower surface of a projection 16 protruding outward from an upper portion of the sidewall of the housing 10.

By designing the length of the rail cooperating portion 21 and/or the position of the second stop surface 15, the second stop surface 15 could be located just next to the upper end 25 of the rail cooperating portion 21 when the press-on element 20 is in the mounted position on the housing 10. Therefore, the second stop surface 15 could prevent the press-on element 20 from moving upward relative to the housing 10 by cooperating (abutting) the upper end portion 25 of the rail cooperating portion 21.

It could be understood that only after the press-on element 20 has reached the mounted position, the cooperation between the first limiting portion and the first limiting cooperating portion, and the cooperation between the second limiting portion and the second limiting cooperating portion, could take effect to prevent the press-on element from moving upward/downward relative to the housing.

A process of mounting the press-on element 20 to the housing 10 according to the first embodiment will now be described. After the housing 10 and the press-on element 20 are manufactured separately, the rail cooperating portions 21 of the press-on element 20 are aligned with the corresponding rail portions 11 of the housing 10 from the lower side of the housing 10 (see FIG. 7). Then, the press-on element 20 is moved in the vertically upward direction from the entry position (i.e., the position where the rail cooperating portions 21 have just entered the rail portions 11) on the lower side of the housing 10 to the mounted position shown in FIG. 4. In this process, the top of the main body portion 23 of the press-on element 20 would contact the guiding surface 14 of the protrusions 12 and move along the guiding surfaces 14, thereby slightly swinging elastically relative to the rail cooperating portions 21. Once the windows 22 reach the position where the protrusions 12 are located, the main body portion 23 elastically returns to the position coplanar with the rail cooperating portions 21, i.e., the mounted position, as the protrusions 12 pass through the windows 22.

It can be seen that the press-on element 20 could be mounted to the housing 10 by a simple pushing-in process. After reaching the mounted position, as shown in FIG. 4, the lateral movement of the press-on element 20 is restricted by the rail portions 11, and the upward and downward movements thereof are restricted by the second stop surfaces (second limiting portion) 15 and the protrusions (first limiting portion) 12, respectively, and therefore, the press-on element 20 could be reliably retained at the mounted position.

Further, the press-on element 20 in the first embodiment is detachable relative to the housing 10. When the press-on element 20 needs to be detached from the housing 10, the main body portion 23 of the press-on element 20 may be bent outward with a proper force to cause the windows 22 to be beyond the protrusions 12, and then the press-on element 20 could be pulled out from the housing 10 along the rail portions 11.

Referring to FIG. 8, similar to the structure in US7477518B2, the press-on element 20 is further mounted on the heat sink element D by screws 44 within an inner mounting ring of the press-on element, the inner mounting ring connected to an outer ring, which in turn is connected to the surface coupled to the housing (as represented in figures 4-13). such that the heat-dissipation contact area 30 abuts against the heat sink element D tightly. During operation of the power semiconductor module 1, heat generated by the power semiconductor chip 42 is continuously dissipated to the environment via the heat conductive silicone grease and the heat sink element D. When the edge of the heat-dissipation contact area 30 tends to warp upward due to the heat generated by the semiconductor chip 42, the side walls of the housing 10 also tend to move upward along with the press-on elements 20. However, since the press-on element 20 has been fixed to the heat sink element D at this time, each press-on element 20 applies a downward counterforce to the housing 10, so that the occurrence of the above-mentioned warpage could be effectively suppressed, and in turn the problem that the heat dissipation efficiency of the power semiconductor module is hindered by the thickening of heat conductive silicone grease or even the occurrence of voids in the heat conductive silicone grease at the location where the warpage occurs could be effectively suppressed. Furthermore, since the press-on element 20 is not integrally formed with the housing 10, and the press-on element 20 may be made of a material having a certain elasticity, such as a thin metal sheet, a polymer material sheet, or the like, a flexible contact between the power semiconductor module 1 and the heat sink element D could be achieved, which is advantageous for long-term use, and the reliability of a pressing function could be ensured even in a vibrating environment. In addition, since the press-on element 20 and the housing 10 are separately manufactured, it is not necessary to precisely mold a part of the press-on element 20 to the housing 10. Therefore, the manufacture process of the power semiconductor module 1 is simple and low in cost, and could be applied not only to glue-filled plastic modules but also to plastic encapsulated modules. In addition, since the power semiconductor module 1 does not need to be baled and transported in a state where the press-on element 20 is mount, baling is easy and the transportation size is small.

As illustrated above, the first embodiment according to the present invention has been described with reference to the drawings. In the following description of other embodiments, components corresponding to or having the same functions as those of the components of the first embodiment will be denoted by similar reference numerals (e.g., increased (or multiplied) by hundred(s) from the reference numerals of the components of the first embodiment), and descriptions of some components, operations, effects may be omitted to avoid redundancy.

### Second embodiment

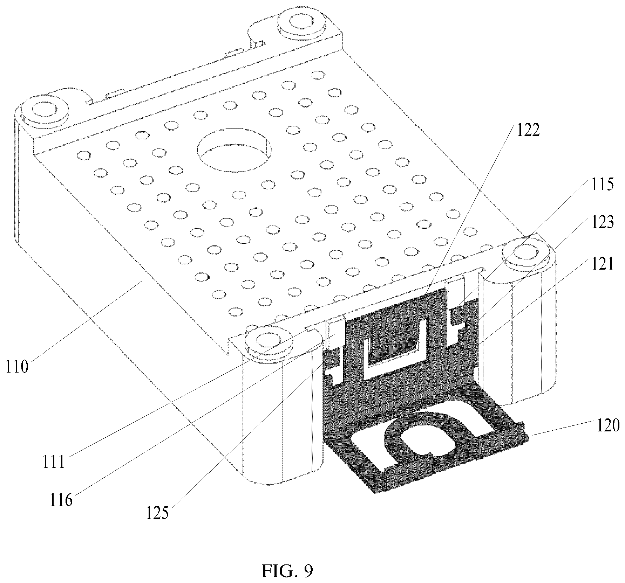

FIGS. 9 to 11 show a housing and a press-on element of a power semiconductor module according to the second embodiment of the present invention. The second embodiment differs from the first embodiment in that the first limiting portion of the housing or the press-on element of the power semiconductor module is configured as a recess 112 on a housing 110, and the first limiting cooperating portion is configured as an elastic element 122 on a main body portion 123 of a press-on element 120. When the press-on element 120 is in the mounted position as shown in FIG. 9, the elastic element 122 could cooperate with the recess 112 to prevent the press-on element 120 from moving relative to the housing 110 in a direction toward the plane where the heat-dissipation contact area 30 is located (i.e., downward in FIG. 9).

Optionally, as shown in FIGS. 9 to 11, the elastic element 122 is an elastic sheet bent and/or tilted toward the housing 10. When the press-on element 120 is in the mounted position, the end of the elastic sheet 122 abuts against a surface of the recess 112 facing away from the plane where the heat-dissipation contact area 30 is located (i.e., against the lower edge of the recess 112).

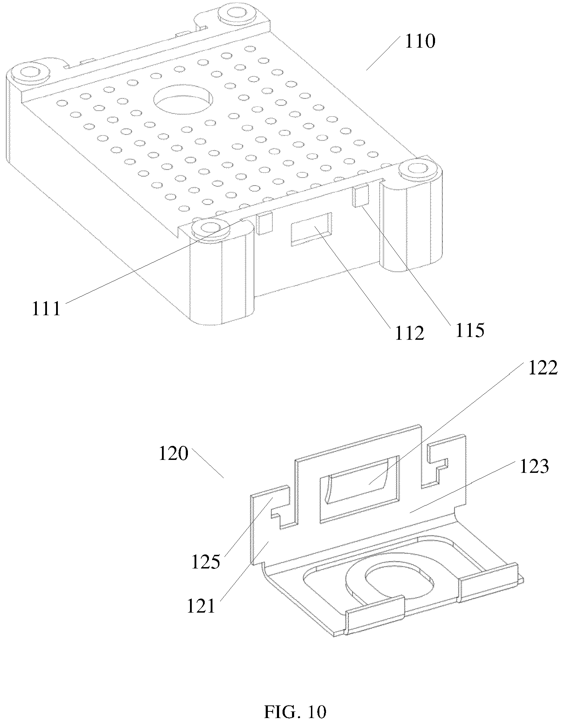

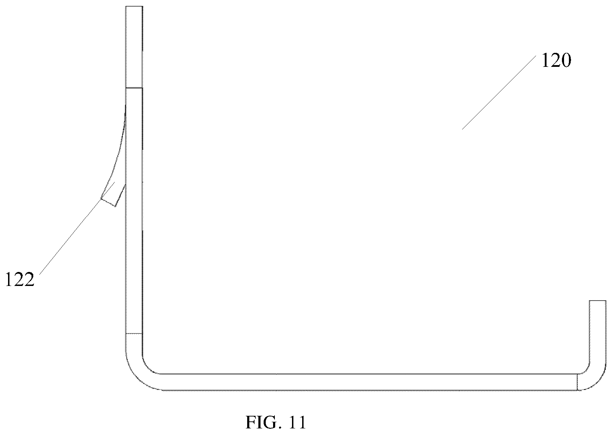

More specifically, as shown in FIG. 10, the recess 112 has a rectangular shape and is located between the two rail portions 111. The elastic element 122 is an elastic sheet extending downward from the upper edge of the window opened in the main body portion 123 of the press-on element 120. In the process of mounting the press-on element 120 to the housing 110 from bottom to top, the tip end of the elastic element 122 would first contact a portion of the sidewall of the housing below the recess 112, so that the elastic element 122 (as well as the main body portion 123) slightly swing forward (to the left in FIG. 11). Once the elastic element 122 reaches a position corresponding to the recess 112, the elastic element 122 is at least partially elastically restored, and the tip end of the elastic element 122 abuts against the lower edge of the recess 112.

Further, in the second embodiment, an upper end portion 125 of the rail cooperating portion 121 has a structure extending laterally toward the first limiting cooperating portion (i.e., the elastic element 122), and only a portion of the upper end portion 25 close to the first limiting cooperating portion serves as the second limiting cooperating portion to be cooperated with the second limiting portion. This structure enables the upper end portion 25 of the rail cooperating portion 121 to produce certain flexibility, which reduces the accuracy requirement for the positional relationship between the second limiting portion and the second limiting cooperating portion, and reduces the influence of vibration when the power semiconductor module is in the mounted state. This structure of the upper end portion 125 can also be applied to the rail cooperating portion 21 in the first embodiment, and will not be described in detail.

### Third embodiment

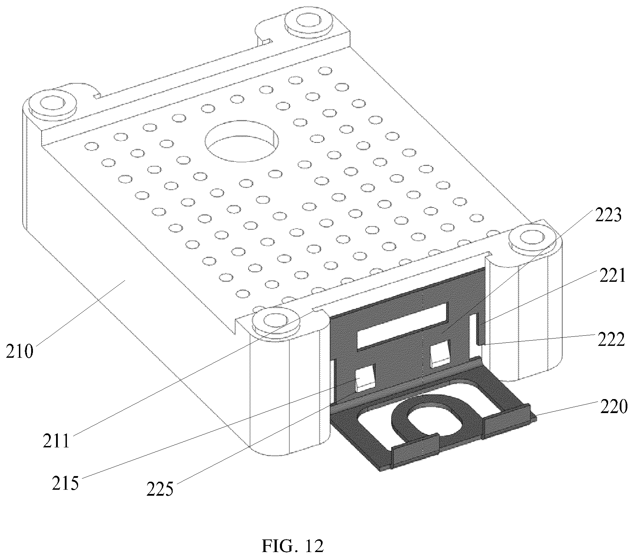

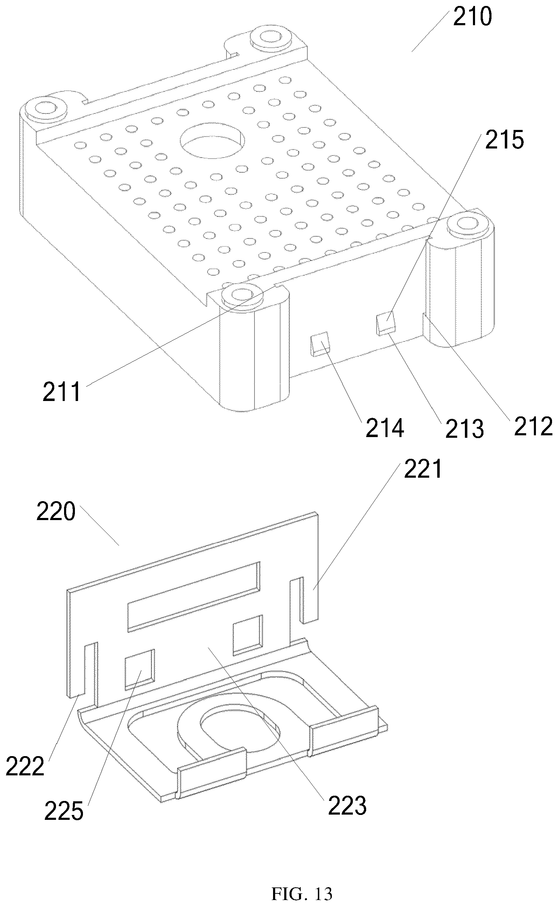

FIGS. 12 and 13 show a housing and a press-on element of a power semiconductor module according to the third embodiment of the present invention. The third embodiment differs from the first and second embodiments in that, a press-on element 220 of the power semiconductor module of the third embodiment is configured to be adapted to move from an entry position of a housing 210 on a side away from the heat-dissipation contact area 30 (i.e., an upper side of the housing 210 in FIG. 12) to a mounted position in a direction toward the plane where the heat-dissipation contact area 30 is located (i.e., a downward direction in FIG. 12). In addition, the first limiting portion in the third embodiment is a first stop surface 212 on the housing 210. When the press-on element 220 is in the mounted position, the first limiting cooperating portion could engage the first stop surface 212 to prevent the press-on element 220 from moving downward.

Specifically, as shown in FIG. 13, the first stop surface 212 is located in a portion of a rail portion 211 close to the heat-dissipation contact area (i.e., a lower portion of the rail portion 211), and could be a rail cut-off surface of the rail portion 211. The first limiting cooperating portion is configured as a lower end portion 222 of a rail cooperating portion 221. When the press-on element 220 is in the mounted position shown in FIG. 12, the lower end 222 of the rail cooperating portion 221 cooperates with the first stop surface 212 to prevent the press-on element 220 from moving downward.

Further, the second limiting portion in the third embodiment is configured as a protrusion 215 on the housing 210. This protrusion 215 has a structure opposite to the structure of the protrusion 12 in the first embodiment. That is, the protrusion 215 has a non-returning surface 213 facing downward and a guiding surface 214 extending obliquely upward from the vicinity of the tip end of non-returning surface 213. The guiding surface 214 is also used for guiding the main body portion 223 during the movement of the press-on element 220 from the entry position to the mounted position. The second limiting cooperating portion is configured as a window 225 on the main body portion 223. When the press-on element 220 is in the mounted position, the protrusion 215 passes through the window 225, and the non-returning surface 213 of the protrusion 215 can cooperate with the lower edge of the window 225 to prevent the press-on element 220 from moving relative to the housing 210 in a direction away from the plane where the heat-dissipation contact area 30 is located.

Optionally or additionally, the second limiting cooperating portion may be configured as a lower surface of a coupling portion between the main body portion 223 and the rail cooperating portion 221 of the press-on element 220, and the second limiting portion may be configured as an upper surface of a projection portion protruding from a position on the housing 210 corresponding to the second limiting cooperating portion.

Further, alternatively, the cooperation between the recess and the elastic element as shown in FIGS. 9 to 11 could also be applied to the third embodiment in which the press-on element 220 moves downward from the upper side of the housing 210 to the mounted position (to replace the protrusion 215 and the window 225), which will not be described further herein to avoid redundancy.

### Fourth embodiment

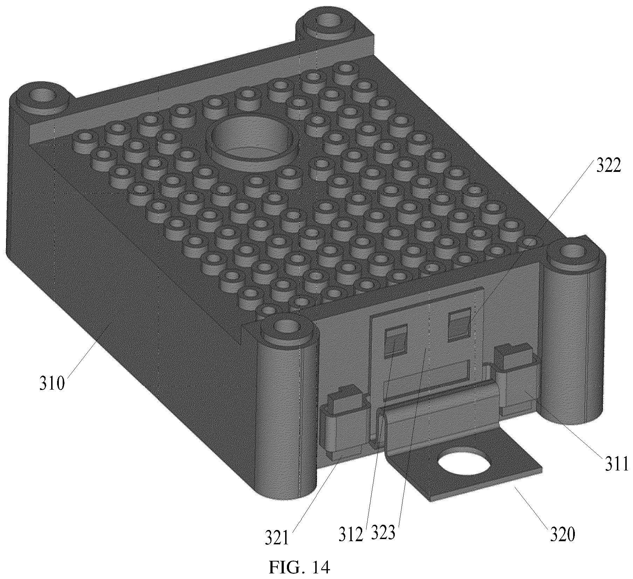

FIG. 14 shows a housing and a press-on element of a power semiconductor module according to the fourth embodiment of the present invention. The fourth embodiment differs from the first embodiment in that rail portions 311 in the fourth embodiment are provided on a press-on element 320, and rail cooperating portions 321 are provided on a housing 310.

Specifically, the rail cooperating portions 321 are configured to project forward from the housing 310 and then be bent to the left and right sides, respectively. The rail portions 311 are configured to laterally project from both sides of a main body portion 323 of the press-on element 320, and are bent into a C-shaped rail shape that are adapted to the cross-sectional shape of the rail cooperating portions 321. The rail cooperating portions 321 are movable in the vertical direction relative to the rail portions 311.

Further, in the fourth embodiment, the second limiting portion is not provided. In this case, the function of preventing the press-on element 320 from moving upward relative to the housing 310 is provided by a screw within an inner mounting ring, the inner mounting ring surrounded by and connected to an outer mounting ring, which in turn is connected to the surface of the press-on element to be coupled to the housing. The screw fixes the press-on element 320 to the heat sink element.

### Fifth embodiment

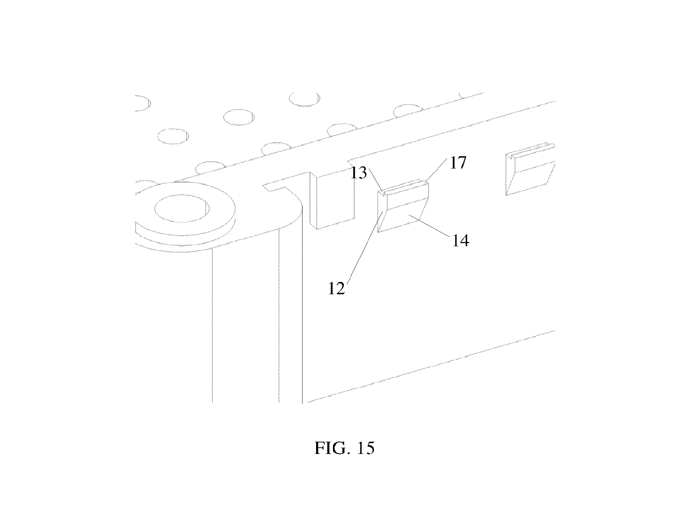

Fig. 15 is a partially enlarged view of a power semiconductor module according to the fifth embodiment of the present invention. The fifth embodiment differs from the first embodiment in that a self-locking structure 17 is provided on the non-returning surface 13 of each protrusion 12. The self-locking structure 17 is configured to be capable of cooperating with an upper outer side surface of the window 22 of the press-on element 20 to prevent, in cooperation with the rail portion 11, the press-on element 20 in the mounted position from moving outward in a direction away from the housing 10. The self-locking structure 17 may be a step or a rib structure provided at the end of the non-returning surface 13.

It will be understood that the self-locking structure 17 may also be applied to the protrusions 215, 312 of the third and fourth embodiments.

For example, although in the above-described embodiments, the number of the press-on elements is two, and two press-on elements are respectively mounted on opposite sides of the housing, the number of the press-on elements may be one or three or more than three as needed. For example, in some applications where space is limited, one side of the power semiconductor module is a copper pin, and the other side is a press-on element. Further, as required, multiple press-on elements may be mounted on different sides of the housing, and/or multiple press-on elements may be mounted on the same side of the housing.

Although in the above-described embodiments, the number of the rail portions or the rail cooperating portions on each of the press-on elements is two, it is also possible that the number is one or three or more than three.

Although in the above-described embodiments, the numbers of the protrusions and the windows to which the protrusions correspond are two, it is also possible that the numbers are one or three or more.

Although in the above-described embodiments, the press-on element is formed in a substantially L shape, the press-on element may have other configurations. The present invention does not make any special limitation on the structure of the pressing member other than the portion that cooperates with the housing.

Although in the above embodiments, the press-on element is a metal element and the housing is a plastic element, other materials may be used to manufacture the press-on element or the housing as required.

Although in the above-described embodiments, the press-on element is detachable relative to the housing, it is also possible to design the press-on element in a form that is not detachable from the housing, as required. In this case, for example, a tamper-proof cover capable of shielding the main body portion of the press-on element may be provided outside the housing to avoid accessing the main body portion already in the mounted position from the outside.

Although in the above-described embodiments, the first/second limiting portion, the first/second limiting cooperating portion, the rail portion, and the rail cooperating portion are integrally formed on the housing or the press-on element, respectively, a part of the above-described elements may be manufactured separately from the housing and the press-on element, and may be mounted on the housing or the press-on element after being manufactured, as required. Furthermore, some of the above elements may be configured such that their size or position is adjustable.

Although in the above-described embodiments, the cooperation between the first limiting portion and the first limiting cooperating portion, and the cooperation between the second limiting portion and the second limiting cooperating portion are contact cooperation, more specifically, are abutting cooperation (abutting against each other), alternatively, the cooperation between the first limiting portion and the first limiting cooperating portion and/or the cooperation between the second limiting portion and the second limiting cooperating portion may be a pin cooperation or a screw cooperation.

Although in the embodiment shown in FIG. 8, the heat-dissipation contact area 30 is the bottom surface of the power semiconductor substrate 41 which is a DBC substrate, the power semiconductor substrate may be constituted by a printed circuit board, a lead frame, an AMB (active metal solder) substrate, an IMS (insulated metal substrate), or the like, and the power semiconductor substrate may be integrated with the housing 10. In addition, the heat-dissipation contact area may also be at least partially composed of a bottom surface of the power semiconductor chip, or a heat dissipation layer attached to the power semiconductor substrate, or the like.

## Claims

1. A power semiconductor module (1), including:
a heat-dissipation contact area (30) configured for thermal connection with a heat sink element,
a housing (10), and
a press-on element (20) manufactured separately from the housing (10), the press-on element (20) comprises a first surface and a second surface perpendicular to said first surface,
**characterized in that**,
one of the housing (10) and the first surface of the press-on element (20) includes a rail portion (11), and the other includes a rail cooperating portion (21), and one of the housing (10) and the first surface of the press-on element (20) includes a first limiting portion, and the other includes a first limiting cooperating portion, wherein the rail cooperating portion is capable of being inserted into the rail portion and sliding in the rail portion in a direction toward or away from a plane where the heat-dissipation contact area is located, such that the first surface of the press-on element (20) is capable of moving from a separation position in which the first surface of the press-on element (20) is separated from the housing (10) to a mounted position in which the first surface of the press-on element (20) is connected to the housing (10),
the rail portion is capable of cooperating with the rail cooperating portion to prevent the first surface of the press-on element (20) from moving relative to the housing (10) in a direction parallel to the plane where the heat-dissipation contact area is located,
the first limiting portion is capable of cooperating with the first limiting cooperating portion to prevent the first surface of the press-on element (20) from moving relative to the housing (10) in a direction toward the plane where the heat-dissipation contact area is located when the first surface of the press-on element (20) is in the mounted position, and
the second surface of the press-on element (20) is configured to press the heat-dissipation contact area against the heat sink element when the first surface of the press-on element (10) is in the mounted position and the second surface of the press-on element (20) is mounted to the heat sink element, wherein
the head-dissipation contact area (30) is a bottom surface of a power semiconductor substrate (41), said power semiconductor (41) embedded at the bottom of the housing (10), wherein power semiconductor chips (42) are provided on a top surface of the power semiconductor substrate (41) and are located within the housing (10), and a plurality of terminal pins (43) extend from the power semiconductor chip (42) or the power semiconductor substrate (41) toward a direction away from the head-dissipation contact area (30) and pass out of the housing (10) from through holes at the top of the housing (10), and
wherein the second surface of the press-on element (20) comprises an outer mounting ring connected to the first surface of the press-on element (20) and surrounding, and connected to, an inner mounting ring, said inner mounting ring configured to receive a screw (44) within said ring, wherein the screw is configured to couple the heat sink element to the press-on element (20)

2. The power semiconductor module according to claim 1, **characterized in that**,
the rail portion is located on the housing (10),
the first surface of the press-on element (20) further includes a main body portion (23), and
the rail cooperating portion (21) is configured to project laterally from the main body portion and extend in a direction in which the rail portion extends.

3. The power semiconductor module according to claim 2, **characterized in that**,
the first surface of the press-on element (20) is configured to be adapted to move from an entry position on a side of the housing close to the heat-dissipation contact area to the mounted position in a direction away from the plane where the heat-dissipation contact area is located,
the first limiting portion is configured as a protrusion (12) on the housing (10), the protrusion having a non-returning surface (13) facing away from the plane where the heat-dissipation contact area is located, and a guiding surface (14) extending obliquely from a tip end of the non-returning surface toward the heat-dissipation contact area, the guiding surface being used for guiding the main body portion during movement of the first surface of the press-on element (20) from the entry position to the mounted position, and
the first limiting cooperating portion is configured as a window (22) on the main body portion, wherein when the press-on element is in the mounted position, the protrusion passes through the window, and the non-returning surface (13) of the protrusion is capable of cooperating with a surface of the window facing the plane where the heat-dissipation contact area is located to prevent the press-on element from moving relative to the housing in a direction toward the plane where the heat-dissipation contact area is located.

4. The power semiconductor module according to claim 2, **characterized in that**,
the first surface of the press-on element (20) is configured to be adapted to move from an entry position on a side of the housing (10) close to the heat-dissipation contact area to the mounted position in a direction away from the plane where the heat-dissipation contact area is located,
the first limiting portion is configured as a recess (112) on the housing, and
the first limiting cooperating portion is configured as an elastic element (122) on the main body portion, wherein when the press-on element is in the mounted position, the elastic element is capable of cooperating with the recess to prevent the press-on element from moving relative to the housing in a direction toward the plane where the heat-dissipation contact area is located.

5. The power semiconductor module according to claim 4, **characterized in that**, the elastic element is an elastic sheet that is bent and/or tilted toward the housing, and when the press-on element is in the mounted position, a tip end of the elastic sheet abuts against a surface of the recess facing away from the plane where the heat-dissipation contact area is located.

6. The power semiconductor module according to claim 2, **characterized in that**,
the first surface of the press-on element (20) is configured to be adapted to move from an entry position on a side of the housing (10) away from the heat-dissipation contact area to the mounted position in a direction toward the plane where the heat-dissipation contact area is located,
the first limiting portion is a first stop surface on the housing, and
when the press-on element is in the mounted position, the first limiting cooperating portion is capable of cooperating with the first stop surface to prevent the press-on element from moving relative to the housing in a direction toward the plane where the heat-dissipation contact area is located.

7. The power semiconductor module according to claim 6, **characterized in that**,
the rail portion is located on the housing (10), the first stop surface is located in a portion of the rail portion close to the heat-dissipation contact area, the rail cooperating portion is located on the press-on element, and the first limiting cooperating portion is located at an end of the rail cooperating portion, and
when the press-on element is in the mounted position, the first limiting cooperating portion is capable of cooperating with the first stop surface to prevent the press-on element from moving relative to the housing in a direction toward the plane where the heat-dissipation contact area is located.

8. The power semiconductor module according to claim 1, **characterized in that**, the press-on element (20) is made of a material having elasticity.

9. The power semiconductor module according to claim 1, **characterized in that**, the housing (10) and the first surface of the press-on element (20) include a second limiting portion and a second limiting cooperating portion, respectively, and
when the first surface of the press-on element (20) is in the mounted position, the second limiting portion is capable of cooperating with the second limiting cooperating portion to prevent the press-on element from moving relative to the housing in a direction away from the plane where the heat-dissipation contact area is located.

10. The power semiconductor module according to any one of claims 3 to 5, **characterized in that**,
the housing (10) and the first surface of the press-on element (20) include a second limiting portion and a secondlimiting cooperating portion, respectively,
the second limiting portion is configured as a second stop surface (15) facing the plane where the heat dissipation contact area is located, and the second limiting cooperating portion is located at an end of the main body portion or the rail cooperating portion, and
when the press-on element is in the mounted position, the second stop surface is capable of cooperating with the second limiting cooperating portion to prevent the press-on element from moving relative to the housing in a direction away from the plane where the heat-dissipation contact area is located.

11. The power semiconductor module according to claim 6 or 7, **characterized in that**,
the housing (10) and the first surface of the press-on element (20) include a second limiting portion and a second limiting cooperating portion, respectively,
the second limiting portion is configured as a protrusion (215) on the housing, the protrusion having a non-returning surface facing away from the plane where the heat-dissipation contact area is located, and a guiding surface extending obliquely away from the plane where the heat-dissipation contact area is located from a tip end of the non-returning surface, the guiding surface being used for guiding the main body portion during movement of the press-on element from the entry position to the mounted position, and
the second limiting cooperating portion is configured as a window (225) on the main body portion, wherein when the press-on element is in the mounted position, the protrusion passes through the window, and the non-returning surface of the protrusion is capable of cooperating with a surface of the window away from the plane where the heat-dissipation contact area is located to prevent the press-on element from moving relative to the housing in a direction away from the plane where the heat-dissipation contact area is located.

12. The power semiconductor module of claim 3, **characterized in that**,
a self-locking structure (17) is provided on the non-returning surface, the self-locking structure is configured to be capable of cooperating with the window to prevent the press-on element in the mounted position from moving outward in a direction away from the housing.

13. The power semiconductor module of claim 11, **characterized in that**,
a self-locking structure (17) is provided on the non-returning surface, and the self-locking structure is configured to be capable of cooperating with the window to prevent the press-on element in the mounted position from moving outward in a direction away from the housing.

14. The power semiconductor module according to any one of claims 2 to 5 and 7, **characterized in that**,
the numbers of the rail portions and the rail cooperating portions are two, respectively; and spaces in the two rail portions for accommodating the corresponding rail cooperating portions are opened toward each other.

15. The power semiconductor module according to any one of claims 1 to 9, **characterized in that**,
the number of the press-on elements is at least two, and
in the mounted position, two of the press-on elements are mounted on opposite sides of the housing, respectively.

16. The power semiconductor module according to any one of claims 1 to 9, **characterized in that**,
the press-on element is adapted to be detachably mounted to the housing.

17. The power semiconductor module according to any one of claims 1 to 9, **characterized in that**, the power semiconductor module meets at least one of the following conditions:
the first limiting portion is integrally formed on the housing;
the first limiting cooperating portion is integrally formed on the press-on element;
the rail portion is integrally formed on the housing or the press-on element;
the rail cooperating portion is integrally formed on the housing or the press-on element;
the housing is made of plastic;
the press-on element is made of metal.

18. A method for assembling the power semiconductor module according to any one of claims 1 to 17 to the heat sink element, **characterized in that**, the method includes:
placing the press-on element at an entry position on the housing, sliding the rail cooperating portion in the rail portion to move the press-on element from the entry position to the mounted position, and
mounting the press-on element on the heat sink element such that the heat-dissipation contact area abuts against the heat sink element tightly.

19. The method of claim 18, **characterized in that**, before mounting the press-on element to the heat sink element, the method further includes: applying a heat conductive silicone grease on the heat-dissipation contact area and/or the surface of the heat sink element.

## Patentansprüche

1. Leistungshalbleitermodul (1), einschließlich:
eines Wärmeableitungskontaktbereichs (30), der für eine thermische Verbindung mit einem Kühlkörperelement konfiguriert ist,
eines Gehäuses (10), und
eines Aufpresselements (20), das getrennt von dem Gehäuse (10) hergestellt ist, wobei das Aufpresselement (20) eine erste Oberfläche und eine zweite Oberfläche rechtwinklig zu der ersten Oberfläche umfasst, **dadurch gekennzeichnet, dass**,
eines von dem Gehäuse (10) und der ersten Oberfläche des Aufpresselements (20) einen Schienenabschnitt (11) einschließt und das andere einen Schienenzusammenwirkungsabschnitt (21) einschließt, und eines von dem Gehäuse (10) und der ersten Oberfläche des Aufpresselements (20) einen ersten begrenzenden Abschnitt einschließt und das andere einen ersten begrenzenden Zusammenwirkungsabschnitt einschließt, wobei der Schienenzusammenwirkungsabschnitt in der Lage ist, in den Schienenabschnitt eingeführt zu werden und in dem Schienenabschnitt in einer Richtung zu oder weg von einer Ebene zu gleiten, in der sich der Wärmeableitungskontaktbereich befindet, so dass die erste Oberfläche des Aufpresselements (20) in der Lage ist, sich von einer Trennposition, in der die erste Oberfläche des Aufpresselements (20) von dem Gehäuse (10) getrennt ist, zu einer montierten Position zu bewegen, in der die erste Oberfläche des Aufpresselements (20) mit dem Gehäuse (10) verbunden ist,
der Schienenabschnitt in der Lage ist, mit dem Schienenzusammenwirkungsabschnitt zusammenzuwirken, um zu verhindern, dass sich die erste Oberfläche des Aufpresselements (20) relativ zu dem Gehäuse (10) in einer Richtung parallel zu der Ebene bewegt, in der sich der Wärmeableitungskontaktbereich befindet,
der erste begrenzende Abschnitt in der Lage ist, mit dem ersten begrenzenden Zusammenwirkungsabschnitt zusammenzuwirken, um zu verhindern, dass sich die erste Oberfläche des Aufpresselements (20) relativ zu dem Gehäuse (10) in einer Richtung zu der Ebene hin bewegt, in der sich der Wärmeableitungskontaktbereich befindet, wenn die erste Oberfläche des Aufpresselements (20) in der montierten Position ist, und
die zweite Oberfläche des Aufpresselements (20) konfiguriert ist, um den Wärmeableitungskontaktbereich gegen das Kühlkörperelement zu pressen, wenn die erste Oberfläche des Aufpresselements (10) in der montierten Position ist und die zweite Oberfläche des Aufpresselements (20) an dem Kühlkörperelement montiert ist, wobei
der Wärmeableitungskontaktbereich (30) eine untere Oberfläche eines Leistungshalbleitersubstrats (41) ist, wobei der Leistungshalbleiter (41) am Boden des Gehäuses (10) eingebettet ist, wobei Leistungshalbleiterchips (42) auf einer oberen Oberfläche des Leistungshalbleitersubstrats (41) bereitgestellt sind und sich innerhalb des Gehäuses (10) befinden, und eine Vielzahl von Anschlussstiften (43) sich von dem Leistungshalbleiterchip (42) oder dem Leistungshalbleitersubstrat (41) in einer Richtung weg von dem Wärmeableitungskontaktbereich (30) erstrecken und aus dem Gehäuse (10) aus Durchgangslöchern an der Oberseite des Gehäuses (10) herausführen, und
wobei die zweite Oberfläche des Aufpresselements (20) einen äußeren Montagering umfasst, der mit der ersten Oberfläche des Aufpresselements (20) verbunden ist und einen inneren Montagering umgibt und mit diesem verbunden ist, wobei der innere Montagering konfiguriert ist, um eine Schraube (44) innerhalb des Rings aufzunehmen, wobei die Schraube konfiguriert ist, um das Kühlkörperelement mit dem Aufpresselement (20) zu koppeln.

2. Leistungshalbleitermodul nach Anspruch 1, **dadurch gekennzeichnet, dass**
der Schienenabschnitt sich am Gehäuse (10) befindet,
die erste Oberfläche des Aufpresselements (20) ferner einen Hauptkörperabschnitt (23) einschließt und
der Schienenzusammenwirkungsabschnitt (21) konfiguriert ist, um seitlich von dem Hauptkörperabschnitt vorzustehen und sich in einer Richtung zu erstrecken, in der sich der Schienenabschnitt erstreckt.

3. Leistungshalbleitermodul nach Anspruch 2, **dadurch gekennzeichnet, dass**
die erste Oberfläche des Aufpresselements (20) so konfiguriert ist, dass sie angepasst ist, um sich von einer Eintrittsposition auf einer Seite des Gehäuses in der Nähe des Wärmeableitungskontaktbereichs in die montierte Position in einer Richtung weg von der Ebene zu bewegen, in der sich der Wärmeableitungskontaktbereich befindet,
der erste begrenzende Abschnitt als ein Vorsprung (12) am Gehäuse (10) konfiguriert ist, wobei der Vorsprung eine nicht zurückkehrende Oberfläche (13), die von der Ebene, in der sich der Wärmeableitungskontaktbereich befindet, abgewandt ist, und eine Führungsoberfläche (14) aufweist, die sich schräg von einem Spitzenende der nicht zurückkehrenden Oberfläche hin zum Wärmeableitungskontaktbereich erstreckt, wobei die Führungsoberfläche zum Führen des Hauptkörperabschnitts während der Bewegung der ersten Oberfläche des Aufpresselements (20) von der Eintrittsposition in die montierte Position verwendet wird, und
der erste begrenzende Zusammenwirkungsabschnitt als ein Fenster (22) auf dem Hauptkörperabschnitt konfiguriert ist, wobei, wenn das Aufpresselement in der montierten Position ist, der Vorsprung durch das Fenster hindurchgeht und die nicht zurückkehrende Oberfläche (13) des Vorsprungs in der Lage ist, mit einer Oberfläche des Fensters zusammenzuwirken, die der Ebene zugewandt ist, in der sich der Wärmeableitungskontaktbereich befindet, um zu verhindern, dass sich das Aufpresselement relativ zu dem Gehäuse in einer Richtung zu der Ebene hin bewegt, in der sich der Wärmeableitungskontaktbereich befindet.

4. Leistungshalbleitermodul nach Anspruch 2, **dadurch gekennzeichnet, dass**
die erste Oberfläche des Aufpresselements (20) so konfiguriert ist, dass sie angepasst ist, um sich von einer Eintrittsposition auf einer Seite des Gehäuses (10) in der Nähe des Wärmeableitungskontaktbereichs in die montierte Position in einer Richtung weg von der Ebene zu bewegen, in der sich der Wärmeableitungskontaktbereich befindet,
der erste begrenzende Abschnitt als eine Aussparung (112) an dem Gehäuse konfiguriert ist, und
der erste begrenzende Zusammenwirkungsabschnitt als ein elastisches Element (122) an dem Hauptkörperabschnitt konfiguriert ist, wobei, wenn das Aufpresselement in der montierten Position ist, das elastische Element in der Lage ist, mit der Aussparung zusammenzuwirken, um zu verhindern, dass sich das Aufpresselement relativ zu dem Gehäuse in einer Richtung zu der Ebene hin bewegt, in der sich der Wärmeableitungskontaktbereich befindet.

5. Leistungshalbleitermodul nach Anspruch 4, **dadurch gekennzeichnet, dass** das elastische Element ein elastisches Blatt ist, das hin zum Gehäuse gebogen und/oder gekippt ist, und dass, wenn das Aufpresselement in der montierten Position ist, ein Spitzenende des elastischen Blattes an einer Oberfläche der Aussparung anliegt, die von der Ebene abgewandt ist, in der sich der Wärmeableitungskontaktbereich befindet.

6. Leistungshalbleitermodul nach Anspruch 2, **dadurch gekennzeichnet, dass**
die erste Oberfläche des Aufpresselements (20) so konfiguriert ist, dass sie angepasst ist, um sich von einer Eintrittsposition auf einer Seite des Gehäuses (10), die von dem Wärmeableitungskontaktbereich entfernt ist, in die montierte Position in Richtung hin zu der Ebene, in der sich der Wärmeableitungskontaktbereich befindet, zu bewegen,
der erste begrenzende Abschnitt eine erste Anschlagoberfläche am Gehäuse ist, und
wenn das Aufpresselement in der montierten Position ist, der erste begrenzende Zusammenwirkungsabschnitt in der Lage ist, mit der ersten Anschlagoberfläche zusammenzuwirken, um zu verhindern, dass sich das Aufpresselement relativ zu dem Gehäuse in einer Richtung hin zu der Ebene bewegt, in der sich der Wärmeableitungskontaktbereich befindet.

7. Leistungshalbleitermodul nach Anspruch 6, **dadurch gekennzeichnet, dass**
der Schienenabschnitt sich auf dem Gehäuse (10) befindet, die erste Anschlagoberfläche sich in einem Abschnitt des Schienenabschnitts in der Nähe des Wärmeableitungskontaktbereichs befindet, der Schienenzusammenwirkungsabschnitt sich auf dem Aufpresselement befindet, und der erste begrenzende Zusammenwirkungsabschnitt sich an einem Ende des Schienenzusammenwirkungsabschnitts befindet, und
wenn das Aufpresselement in der montierten Position ist, der erste begrenzende Zusammenwirkungsabschnitt in der Lage ist, mit der ersten Anschlagoberfläche zusammenzuwirken, um zu verhindern, dass sich das Aufpresselement relativ zu dem Gehäuse in einer Richtung hin zu der Ebene bewegt, in der sich der Wärmeableitungskontaktbereich befindet.

8. Leistungshalbleitermodul nach Anspruch 1, **dadurch gekennzeichnet, dass** das Aufpresselement (20) aus einem Material, das Elastizität aufweist, hergestellt ist.

9. Leistungshalbleitermodul nach Anspruch 1, **dadurch gekennzeichnet, dass** das Gehäuse (10) und die erste Oberfläche des Aufpresselements (20) jeweils einen zweiten begrenzenden Abschnitt und einen zweiten begrenzenden Zusammenwirkungsabschnitt einschließen, und
wenn die erste Oberfläche des Aufpresselements (20) in der montierten Position ist, der zweite begrenzende Abschnitt in der Lage ist, mit dem zweiten begrenzenden Zusammenwirkungsabschnitt zusammenzuwirken, um zu verhindern, dass sich das Aufpresselement relativ zu dem Gehäuse in einer Richtung weg von der Ebene bewegt, in der sich der Wärmeableitungskontaktbereich befindet.

10. Leistungshalbleitermodul nach einem der Ansprüche 3 bis 5, **dadurch gekennzeichnet, dass**
das Gehäuse (10) und die erste Oberfläche des Aufpresselements (20) einen zweiten begrenzenden Abschnitt bzw. einen zweiten begrenzenden Zusammenwirkungsabschnitt einschließen,
der zweite begrenzende Abschnitt als eine zweite Anschlagoberfläche (15) konfiguriert ist, die der Ebene zugewandt ist, in der sich der Wärmeableitungskontaktbereich befindet, und der zweite begrenzende Zusammenwirkungsabschnitt sich an einem Ende des Hauptkörperabschnitts oder des Schienenzusammenwirkungsabschnitts befindet, und
wenn das Aufpresselement in der montierten Position ist, die zweite Anschlagoberfläche in der Lage ist, mit dem zweiten begrenzenden Zusammenwirkungsabschnitt zusammenzuwirken, um zu verhindern, dass sich das Aufpresselement relativ zu dem Gehäuse in einer Richtung weg von der Ebene bewegt, in der sich der Wärmeableitungskontaktbereich befindet.

11. Leistungshalbleitermodul nach Anspruch 6 oder 7, **dadurch gekennzeichnet, dass**
das Gehäuse (10) und die erste Oberfläche des Aufpresselements (20) einen zweiten begrenzenden Abschnitt bzw. einen zweiten begrenzenden Zusammenwirkungsabschnitt einschließen,
der zweite begrenzende Abschnitt als ein Vorsprung (215) am Gehäuse konfiguriert ist, wobei der Vorsprung eine nicht zurückkehrende Oberfläche, die von der Ebene, in der sich der Wärmeableitungskontaktbereich befindet, abgewandt ist, und eine Führungsoberfläche aufweist, die sich schräg von der Ebene, in der sich der Wärmeableitungskontaktbereich befindet, von einem Spitzenende der nicht zurückkehrenden Oberfläche weg erstreckt, wobei die Führungsoberfläche zum Führen des Hauptkörperabschnitts während der Bewegung des Aufpresselements von der Eintrittsposition in die montierte Position verwendet wird, und
der zweite begrenzende Zusammenwirkungsabschnitt als ein Fenster (225) auf dem Hauptkörperabschnitt konfiguriert ist, wobei, wenn das Aufpresselement in der montierten Position ist, der Vorsprung durch das Fenster hindurchgeht und die nicht zurückkehrende Oberfläche des Vorsprungs in der Lage ist, mit einer Oberfläche des Fensters zusammenzuwirken, die von der Ebene abgewandt ist, in der sich der Wärmeableitungskontaktbereich befindet, um zu verhindern, dass sich das Aufpresselement relativ zu dem Gehäuse in einer Richtung weg von der Ebene bewegt, in der sich der Wärmeableitungskontaktbereich befindet.

12. Leistungshalbleitermodul nach Anspruch 3, **dadurch gekennzeichnet, dass**
eine selbstverriegelnde Struktur (17) auf der nicht zurückkehrenden Oberfläche bereitgestellt ist, wobei die selbstverriegelnde Struktur konfiguriert ist, um in der Lage zu sein, mit dem Fenster zusammenzuwirken, um zu verhindern, dass sich das Aufpresselement in der montierten Position nach außen in einer Richtung weg vom Gehäuse bewegt.

13. Leistungshalbleitermodul nach Anspruch 11, **dadurch gekennzeichnet, dass**
eine selbstverriegelnde Struktur (17) auf der nicht zurückkehrenden Oberfläche bereitgestellt ist, und wobei die selbstverriegelnde Struktur konfiguriert ist, um in der Lage zu sein, mit dem Fenster zusammenzuwirken, um zu verhindern, dass sich das Aufpresselement in der montierten Position nach außen in einer Richtung weg vom Gehäuse bewegt.

14. Leistungshalbleitermodul nach einem der Ansprüche 2 bis 5 und 7, **dadurch gekennzeichnet, dass**
die Anzahl der Schienenabschnitte und der Schienenzusammenwirkungsabschnitte jeweils zwei ist; und Räume in den beiden Schienenabschnitten zum Aufnehmen der entsprechenden Schienenzusammenwirkungsabschnitte zueinander hin geöffnet sind.

15. Leistungshalbleitermodul nach einem der Ansprüche 1 bis 9, **dadurch gekennzeichnet, dass**
die Anzahl der Aufpresselemente mindestens zwei ist und
in der montierten Position jeweils zwei der Aufpresselemente auf gegenüberliegenden Seiten des Gehäuses montiert sind.

16. Leistungshalbleitermodul nach einem der Ansprüche 1 bis 9, **dadurch gekennzeichnet, dass**
das Aufpresselement angepasst ist, um lösbar am Gehäuse montiert zu werden.

17. Leistungshalbleitermodul nach einem der Ansprüche 1 bis 9, **dadurch gekennzeichnet, dass**
das Leistungshalbleitermodul mindestens eine der folgenden Bedingungen erfüllt:
der erste begrenzende Abschnitt ist einstückig an dem Gehäuse ausgebildet;
der erste begrenzende Zusammenwirkungsabschnitt ist einstückig an dem Aufpresselement ausgebildet;
der Schienenabschnitt ist einstückig an dem Gehäuse oder dem Aufpresselement ausgebildet;
der Schienenzusammenwirkungsabschnitt ist einstückig an dem Gehäuse oder dem Aufpresselement ausgebildet;
das Gehäuse ist aus Kunststoff hergestellt;
das Aufpresselement ist aus Metall hergestellt.

18. Verfahren zum Zusammenbauen des Leistungshalbleitermoduls nach einem der Ansprüche 1 bis 17 mit dem Kühlkörperelement, **dadurch gekennzeichnet, dass** das Verfahren einschließt:
Platzieren des Aufpresselements an einer Eintrittsposition auf dem Gehäuse, Verschieben des Schienenzusammenwirkungsabschnitts in dem Schienenabschnitt, um das Aufpresselement von der Eintrittsposition in die montierte Position zu bewegen, und
Montieren des Aufpresselements auf dem Kühlkörperelement, so dass der Wärmeableitungskontaktbereich fest an dem Kühlkörperelement anliegt.

19. Verfahren nach Anspruch 18, **dadurch gekennzeichnet, dass** das Verfahren vor dem Montieren des Aufpresselements auf dem Kühlkörperelement ferner einschließt: Auftragen eines wärmeleitenden Silikonfetts auf den Wärmeableitungskontaktbereich und/oder die Oberfläche des Kühlkörperelements.

## Revendications

1. Module de semi-conducteur de puissance (1), comprenant :
une zone de contact de dissipation de chaleur (30) conçue pour être en connexion thermique avec un élément puits thermique,
un boîtier (10), et
un élément d'appui (20) fabriqué séparément du boîtier (10), l'élément d'appui (20) comprenant une première surface et une deuxième surface perpendiculaire à ladite première surface,
**caractérisé en ce que**
l'un du boîtier (10) et de la première surface de l'élément d'appui (20) comprend une partie rail (11), et l'autre comprend une partie de coopération avec le rail (21), et l'un du boîtier (10) et de la première surface de l'élément d'appui (20) comprend une première partie de limitation, et l'autre comprend une première partie de coopération avec la limitation, la partie de coopération avec le rail pouvant être insérée dans la partie rail et coulisser dans la partie rail dans une direction vers ou s'éloignant d'un plan où se situe la zone de contact de dissipation de chaleur, de telle sorte que la première surface de l'élément d'appui (20) est apte à se déplacer d'une position de séparation dans laquelle la première surface de l'élément d'appui (20) est séparée du boîtier (10) à une position montée dans laquelle la première surface de l'élément d'appui (20) est raccordée au boîtier (10),
la partie rail est apte à coopérer avec la partie de coopération avec le rail afin d'éviter que la première surface de l'élément d'appui (20) bouge par rapport au boîtier (10) dans une direction parallèle au plan où se situe la zone de contact de dissipation de chaleur,
la première partie de limitation est apte à coopérer avec la première partie de coopération avec la limitation afin d'éviter que la première surface de l'élément d'appui (20) bouge par rapport au boîtier (10) dans une direction vers le plan où se situe la zone de contact de dissipation de chaleur quand la première surface de l'élément d'appui (20) est en position montée, et
la deuxième surface de l'élément d'appui (20) est conçue pour presser la zone de contact de dissipation de chaleur contre l'élément puits thermique quand la première surface de l'élément d'appui (10) est en position montée et la deuxième surface de l'élément d'appui (20) est montée sur l'élément puits thermique, dans lequel
la zone de contact de dissipation de chaleur (30) est une surface inférieure d'un substrat de semi-conducteur de puissance (41), ledit semi-conducteur de puissance (41) étant intégré à la base du boîtier (10), les puces semi-conductrices de puissance (42) étant disposées sur une surface supérieure du substrat de semi-conducteur de puissance (41) et étant situées à l'intérieur du boîtier (10), et une pluralité de broches de borne (43) s'étendent depuis la puce semi-conductrice de puissance (42) ou le substrat de semi-conducteur de puissance (41) vers une direction s'éloignant de la zone de contact de dissipation de chaleur (30) et passent hors du boîtier (10) par des trous traversants en haut du boîtier (10), et
dans lequel la deuxième surface de l'élément d'appui (20) comprend un anneau de montage externe raccordé à la première surface de l'élément d'appui (20) et entourant, et raccordé à, un anneau de montage interne, ledit anneau de montage interne étant conçu pour recevoir une vis (44) à l'intérieur dudit anneau, la vis étant conçue pour accoupler l'élément puits thermique à l'élément d'appui (20).

2. Module de semi-conducteur de puissance selon la revendication 1, **caractérisé en ce que**
la partie rail est située sur le boîtier (10),
la première surface de l'élément d'appui (20) comprend en outre une partie corps principal (23), et
la partie de coopération avec le rail (21) est conçue pour se projeter latéralement depuis la partie corps principal et s'étendre dans une direction dans laquelle la partie rail s'étend.

3. Module de semi-conducteur de puissance selon la revendication 2, **caractérisé en ce que**
la première surface de l'élément d'appui (20) est conçue pour être adaptée pour se déplacer depuis une position d'entrée sur un côté du boîtier proche de la zone de contact de dissipation de chaleur vers la position montée dans une direction qui s'éloigne du plan où se situe la zone de contact de dissipation de chaleur,
la première partie de limitation est conçue comme une saillie (12) sur le boîtier (10), la saillie ayant une surface anti-retour (13) orientée à l'opposé du plan où se situe la zone de contact de dissipation de chaleur, et une surface de guidage (14) s'étendant de manière oblique par rapport à une extrémité de pointe de la surface anti-retour vers la zone de contact de dissipation de chaleur, la surface de guidage étant utilisée pour le guidage de la partie corps principal durant un mouvement de la première surface de l'élément d'appui (20) depuis la position d'entrée jusqu'à la position montée, et
la première partie de coopération avec la limitation est conçue comme une fenêtre (22) sur la partie corps principal, dans lequel quand l'élément d'appui est en position montée, la saillie passe à travers la fenêtre, et la surface anti-retour (13) de la saillie est apte à coopérer avec une surface de la fenêtre qui fait face au plan où se situe la zone de contact de dissipation de chaleur pour empêcher que l'élément d'appui bouge par rapport au boîtier dans une direction vers le plan où se situe la zone de contact de dissipation de chaleur.

4. Module de semi-conducteur de puissance selon la revendication 2, **caractérisé en ce que**
la première surface de l'élément d'appui (20) est conçue pour être adaptée pour se déplacer depuis une position d'entrée sur un côté du boîtier (10) proche de la zone de contact de dissipation de chaleur vers la position montée dans une direction qui s'éloigne du plan où se situe la zone de contact de dissipation de chaleur,
la première partie de limitation est conçue comme un creux (112) sur le boîtier, et
la première partie de coopération avec la limitation est conçue comme un élément élastique (122) sur la partie corps principal, dans lequel quand l'élément d'appui est en position montée, l'élément élastique est apte à coopérer avec le creux pour empêcher que l'élément d'appui bouge par rapport au boîtier dans une direction vers le plan où se situe la zone de contact de dissipation de chaleur.

5. Module de semi-conducteur de puissance selon la revendication 4, **caractérisé en ce que** l'élément élastique est une feuille élastique qui est courbée et/ou inclinée vers le boîtier, et quand l'élément d'appui est en position montée, une extrémité de pointe de la feuille élastique vient en butée contre une surface du creux qui est orientée à l'opposé du plan où se situe la zone de contact de dissipation de chaleur.

6. Module de semi-conducteur de puissance selon la revendication 2, **caractérisé en ce que**
la première surface de l'élément d'appui (20) est conçue pour être adaptée pour se déplacer depuis une position d'entrée sur un côté du boîtier (10) éloigné de la zone de contact de dissipation de chaleur vers la position montée dans une direction vers le plan où se situe la zone de contact de dissipation de chaleur,
la première partie de limitation est une première surface d'arrêt sur le boîtier, et
quand l'élément d'appui est en position montée, la première partie de coopération avec la limitation est apte à coopérer avec la première surface d'arrêt afin d'éviter que l'élément d'appui bouge par rapport au boîtier dans une direction vers le plan où se situe la zone de contact de dissipation de chaleur.

7. Module de semi-conducteur de puissance selon la revendication 6, **caractérisé en ce que**
la partie rail est située sur le boîtier (10), la première surface d'arrêt est située dans une partie de la partie rail proche de la zone de contact de dissipation de chaleur, la partie de coopération avec le rail est située sur l'élément d'appui, et la première partie de coopération avec la limitation est située au niveau d'une extrémité de la partie de coopération avec le rail, et
quand l'élément d'appui est en position montée, la première partie de coopération avec la limitation est apte à coopérer avec la première surface d'arrêt afin d'éviter que l'élément d'appui bouge par rapport au boîtier dans une direction vers le plan où se situe la zone de contact de dissipation de chaleur.

8. Module de semi-conducteur de puissance selon la revendication 1, **caractérisé en ce que** l'élément d'appui (20) est constitué d'un matériau ayant une élasticité.

9. Module de semi-conducteur de puissance selon la revendication 1, **caractérisé en ce que** le boîtier (10) et la première surface de l'élément d'appui (20) comprennent une deuxième partie de limitation et une deuxième partie de coopération avec la limitation, respectivement, et
quand la première surface de l'élément d'appui (20) est en position montée, la deuxième partie de limitation est apte à coopérer avec la deuxième partie de coopération avec la limitation afin d'éviter que l'élément d'appui bouge par rapport au boîtier dans une direction qui s'éloigne du plan où se situe la zone de contact de dissipation de chaleur.

10. Module de semi-conducteur de puissance selon l'une quelconque des revendications 3 à 5, **caractérisé en ce que**
le boîtier (10) et la première surface de l'élément d'appui (20) comprennent une deuxième partie de limitation et une deuxième partie de coopération avec la limitation, respectivement,
la deuxième partie de limitation est conçue comme une deuxième surface d'arrêt (15) faisant face au plan où se situe la zone de contact de dissipation de chaleur, et la deuxième partie de coopération avec la limitation se situe au niveau d'une extrémité de la partie de corps principal ou de la partie de coopération avec le rail, et
quand l'élément d'appui est en position montée, la deuxième surface d'arrêt est apte à coopérer avec la deuxième partie de coopération avec la limitation afin d'éviter que l'élément d'appui bouge par rapport au boîtier dans une direction qui s'éloigne du plan où se situe la zone de contact de dissipation de chaleur.

11. Module de semi-conducteur de puissance selon la revendication 6 ou 7, **caractérisé en ce que**
le boîtier (10) et la première surface de l'élément d'appui (20) comprennent une deuxième partie de limitation et une deuxième partie de coopération avec la limitation, respectivement,
la deuxième partie de limitation est conçue comme une saillie (215) sur le boîtier, la saillie ayant une surface anti-retour orientée à l'opposé du plan où se situe la zone de contact de dissipation de chaleur, et une surface de guidage s'étendant de manière oblique en s'éloignant du plan où se situe la zone de contact de dissipation de chaleur depuis une extrémité de pointe de la surface anti-retour, la surface de guidage étant utilisée pour le guidage de la partie corps principal durant un mouvement de l'élément d'appui depuis la position d'entrée jusqu'à la position montée, et
la deuxième partie de coopération avec la limitation est conçue comme une fenêtre (225) sur la partie corps principal, dans lequel quand l'élément d'appui est en position montée, la saillie passe à travers la fenêtre, et la surface anti-retour de la saillie est apte à coopérer avec une surface de la fenêtre éloignée du plan où se situe la zone de contact de dissipation de chaleur pour empêcher que l'élément d'appui bouge par rapport au boîtier dans une direction qui s'éloigne du plan où se situe la zone de contact de dissipation de chaleur.

12. Module de semi-conducteur de puissance selon la revendication 3, **caractérisé en ce que**
une structure auto-verrouillable (17) est fournie sur la surface anti-retour, la structure auto-verrouillable est conçue pour être apte à coopérer avec la fenêtre pour empêcher que l'élément d'appui dans la position montée bouge vers l'extérieur dans une direction qui s'éloigne du boîtier.

13. Module de semi-conducteur de puissance selon la revendication 11, **caractérisé en ce que**
une structure auto-verrouillable (17) est fournie sur la surface anti-retour, et la structure auto-verrouillable est conçue pour être apte à coopérer avec la fenêtre pour empêcher que l'élément d'appui dans la position montée bouge vers l'extérieur dans une direction qui s'éloigne du boîtier.

14. Module de semi-conducteur de puissance selon l'une quelconque des revendications 2 à 5 et 7, **caractérisé en ce que**
les nombres des parties rail et des parties de coopération avec le rail sont de deux, respectivement ; et des espaces dans les deux parties rail destinés à recevoir les parties de coopérations avec le rail correspondantes sont ouverts l'un vers l'autre.

15. Module de semi-conducteur de puissance selon l'une quelconque des revendications 1 à 9, **caractérisé en ce que**
le nombre d'éléments d'appui est d'au moins deux, et
en position montée, deux des éléments d'appui sont montés sur des côtés opposés du boîtier, respectivement.

16. Module de semi-conducteur de puissance selon l'une quelconque des revendications 1 à 9, **caractérisé en ce que**
l'élément d'appui est conçu pour pouvoir être monté amovible sur le boîtier.

17. Module de semi-conducteur de puissance selon l'une quelconque des revendications 1 à 9, **caractérisé en ce que** le module de semi-conducteur de puissance respecte au moins l'une des conditions suivantes :
la première partie de limitation est formée d'une seule pièce avec le boîtier ;
la première partie de coopération avec la limitation est formée d'une seule pièce avec l'élément d'appui ;
la partie rail est formée d'une seule pièce sur le boîtier ou l'élément d'appui ;
la partie de coopération avec le rail est formée d'une seule pièce sur le boîtier ou l'élément d'appui ;
le boîtier est en plastique ;
l'élément d'appui est en métal.

18. Procédé d'assemblage du module de semi-conducteur de puissance selon l'une quelconque des revendications 1 à 17 sur l'élément de puits thermique, **caractérisé en ce que** le procédé comprend les étapes consistant à :
placer l'élément d'appui au niveau d'une position d'entrée sur le boîtier, coulisser la partie de coopération avec le rail dans la partie rail pour bouger l'élément d'appui de la position d'entrée à la position montée, et
monter l'élément d'appui sur l'élément puits thermique de telle sorte que la zone de contact de dissipation de chaleur vienne en butée étroitement contre l'élément puits thermique.

19. Procédé selon la revendication 18, **caractérisé en ce que**, avant le montage de l'élément d'appui sur l'élément puits thermique, le procédé comprend en outre une étape consistant à : appliquer une graisse de silicone conductrice de la chaleur sur la zone de contact de dissipation de chaleur et/ou la surface de l'élément puits thermique.
